(19) **Europäisches Patentamt / European Patent Office / Office européen des brevets**

(11) **EP 4 550 975 A1**

(12) **EUROPEAN PATENT APPLICATION**

(43) Date of publication:
07.05.2025 Bulletin 2025/19

(21) Application number: 24209235.1

(22) Date of filing: 28.10.2024

(51) International Patent Classification (IPC):
$H10D\ 30/01^{(2025.01)}$    $H10D\ 30/47^{(2025.01)}$
$H10D\ 62/17^{(2025.01)}$    $H10D\ 64/23^{(2025.01)}$

(52) Cooperative Patent Classification (CPC):
**H10D 30/4732; H10D 30/015; H10D 62/343;**
**H10D 64/256;** H10D 62/8503; H10D 64/111

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: 30.10.2023  US 202318497482

(71) Applicant: **STMicroelectronics International N.V.**
**1228 Plan-les-Ouates, Geneva (CH)**

(72) Inventors:
• **TRINGALI, Cristina**
**96011 AUGUSTA (SR) (IT)**

• **CONTARINO, Alessandro**
**95027 SAN GREGORIO DI CATANIA (CT) (IT)**
• **PEZZUTO, Raffaella**
**28128 MILANO (IT)**
• **IUCOLANO, Ferdinando**
**95030 GRAVINA DI CATANIA (CT) (IT)**
• **CASTAGNA, Maria Eloisa**
**95123 CATANIA (IT)**
• **CONSTANT, Aurore**
**37100 TOURS (FR)**

(74) Representative: **Studio Torta S.p.A.**
**Via Viotti, 9**
**10121 Torino (IT)**

(54) **BACK BARRIER INTEGRATION SCHEME FOR GAN DEVICES**

(57)     A method for fabricating a GaN device includes providing a semiconductor base material (202) with a first and second side (202A, 202B). The semiconductor base material (202) includes a GaN material, a frontside barrier layer (204), and a backside barrier layer (206). A pGaN region (210) is formed in a first region of the GaN device and an ohmic contact is formed on a second region of the semiconductor base material. The ohmic contact includes one or more front contacts (232) and one or more backside barrier contacts (252) that make direct contact with the backside barrier layer (206).

FIG. 2A

FIG. 2B

EP 4 550 975 A1

**Description**

TECHNICAL FIELD

The present invention relates generally to the field of gallium nitride (GaN) devices, and in particular, to back barrier integration schemes for GaN high electron mobility transistors (HEMTs).

BACKGROUND

Traditionally, GaN heterostructures may be used for high-power and high-frequency field effect transistors. However, they are typically required to work in a normally depletion mode, rather than an enhancement mode (normally-off). Enhancement mode devices are beneficial to guarantee safe operation and drive circuit simplification as well as reduce power expenditure.

A critical issue for enhancement mode devices, especially GaN HEMT power structures, is the trade-off between $R_{on}$ degradation after OFF state condition and the off-state breakdown.

To obtain reasonable values of vertical leakage, it is necessary to compensate for the involuntary n-doping of GaN by means of incorporation of other elements, such iron (Fe) and carbon (C). However, the presence of these elements in GaN HEMT power structures contributes to $R_{on}$ degradation and leads to significant increases in the resistance of power devices.

SUMMARY

Therefore, an aim of the present invention is to devise a solution to the problem indicated above, in particular to reduce $R_{on}$ degradation in GaN devices.

According to the invention, a method for manufacturing a gallium nitride device and a gallium nitride device are provided, as defined in the attached claims.

BRIEF DESCRIPTION OF THE DRAWINGS

Reference will now be made to the accompanying drawings, which are not necessarily drawn to scale, and wherein:

FIG. 1 illustrates an example computing entity to perform one or more steps/operations of one or more fabrication techniques described herein;
FIGS. 2A and 2B illustrate sections of a GaN device in accordance with the present disclosure;
FIG. 3 illustrates an example back barrier contact positioning scheme for the GaN device of FIGS. 2A and 2B;
FIG. 4 shows a top plan view and a sectional view of a GaN HEMT during a first stage fabrication process;
FIGS. 5A-B illustrate an example second stage of a GaN HEMT fabrication process;
FIGS. 6A-B illustrates an example third stage of a GaN HEMT fabrication process; and
FIG. 7 illustrates a flowchart of an example method for fabricating a GaN device.

DETAILED DESCRIPTION

Various example embodiments of the present disclosure are directed to improved GaN devices and systems, apparatuses, products, and methods for fabricating improved GaN devices. The present disclosure describes a method of fabrication for GaN heterostructures that reduce dynamic drain source resistance and $R_{on}$ degradation in GaN devices, to improve upon traditional GaN devices.

The present disclosure describes a GaN heterostructure that decreases $R_{on}$ degradation, while preventing off-state breakdown. This leads to less resistance in power devices, without degrading the devices over time. The GaN heterostructure may be used to improve any power transfer device including consumer-grade battery chargers to commercial electric vehicle chargers.

The description refers to the integration of a back barrier in a GaN heterostructure design that is connected via multiple back barrier contacts and to fabrication techniques for fabricating the GaN heterostructure.

The GaN heterostructure design may replace traditional techniques for optimizing the trade-off between the off-state breakdown and $R_{on}$ degradation, including techniques that utilize additional p-GaN regions grown over an aluminum gallium nitride (AlGaN) layer and connected to a drain. These regions may be replaced and improved upon by implementing back barrier contacts within an ohmic region of a GaN heterostructure.

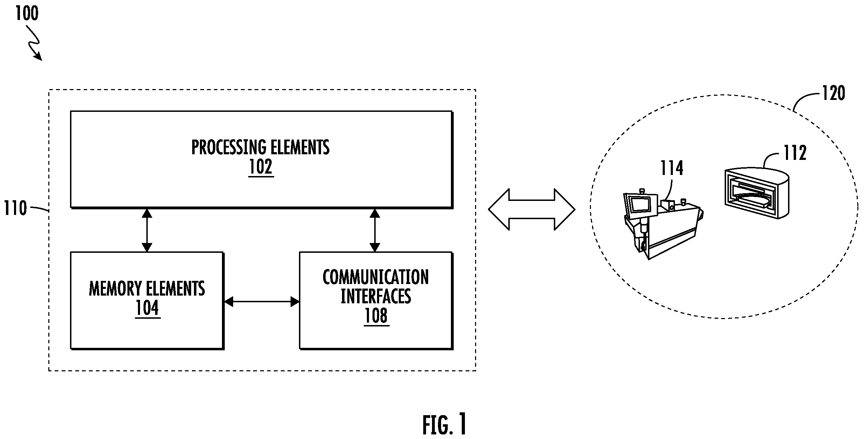

FIG. 1 illustrates an example computing system 100. In general, the terms computing system, computer, system, device, entity, and/or similar words used herein interchangeably may refer to, for example, one or more computers, computing entities, desktops, mobile phones, tablets, notebooks, laptops, distributed systems, kiosks, input terminals, servers or server networks, blades, gateways, switches, processing devices, processing entities, set-top boxes, relays, routers, network access points, base stations, the like, and/or any combination of devices or entities adapted to perform the functions, operations, and/or processes described herein. Such functions, operations, and/or processes may include, for example, transmitting, receiving, operating on, processing, displaying, storing, determining, creating/-generating, monitoring, evaluating, comparing, and/or similar terms used herein interchangeably. In one embodiment, these functions, operations, and/or processes may be performed on data, content, information, and/or similar terms used herein interchangeably.

The computing system 100 includes a computing apparatus 110 and/or one or more computing entities 120 communicatively coupled to the computing apparatus 110 using one or more wired and/or wireless communication techniques. The computing apparatus 110 may include any computing device including, for example, one or more services, computing platforms, and/or the like, that are specially configured to perform one or more steps/operations of the one or more fabrication techniques described herein. The computing apparatus 110 may include and/or be in association with one or more mobile device(s), desktop computer(s), laptop(s), server(s), cloud computing platform(s), and/or the like. The computing apparatus 110 may be configured to receive and/or provide power conversion instructions, data, and/or the like between the one or more computing entities 120 to perform one or more steps/operations of one or more fabrication techniques described herein.

The computing apparatus 110 includes, is integrated with, and/or is otherwise in association with one or more computing entities 120. The one or more computing entities 120 may include one or more semiconductor fabrication devices, such as one or more etching devices 114 (e.g., ion-etching device, chemical etching devices, physical etching devices, etc.), one or more material deposition device 112 (e.g., atomic layer deposition (ALD) devices, plasma enhanced atomic layer deposition (PEALD) devices, plasma enhanced chemical vapor deposition (PECVD) device, sputter vapor deposition, thermal evaporation, arc vapor deposition, etc.), and/or the like. For example, the computing apparatus 110 may be configured to receive and/or provide one or more fabrication instructions between one or more components of the one or more computing entities 120. The computing entities 120, for example, may include and/or be associated with one or more fabrication systems configured to perform one or more fabrication operations for fabricating GaN, and/or other power devices. The one or more fabrication systems, for example, may be configured to fabricate one or more GaN HEMT power devices for use with one or more converters, inverters, power supplies, battery chargers, motor control systems, and/or the like.

The computing apparatus 110 includes, or is in communication with, one or more processing elements 102 (also referred to as processors, processing circuitry, digital circuitry, and/or similar terms used herein interchangeably) that communicate with other elements within the computing apparatus 110 via a bus, for example. As will be understood, the processing element 102 may be embodied in a number of different ways.

For example, the processing element 102 may be embodied as one or more complex programmable logic devices (CPLDs), microprocessors, multi-core processors, coprocessing entities, application-specific instruction-set processors (ASIPs), microcontrollers, and/or controllers. Further, the processing element 102 may be embodied as one or more other processing devices or circuitry. The term circuitry may refer to an entirely hardware embodiment or a combination of hardware and computer program products. Thus, the processing element 102 may be embodied as integrated circuits, application specific integrated circuits (ASICs), field programmable gate arrays (FPGAs), programmable logic arrays (PLAs), hardware accelerators, digital circuitry, and/or the like.

As will therefore be understood, the processing element 102 may be configured for a particular use or configured to execute instructions stored in volatile or non-volatile media or otherwise accessible to the processing element 102. As such, whether configured by hardware or computer program products, or by a combination thereof, the processing element 102 may be capable of performing steps or operations according to embodiments of the present disclosure when configured accordingly.

The computing apparatus 110 further includes, or is in communication with, one or more memory elements 104. The one or more memory elements 104 may include non-volatile and/or volatile media. The memory elements 104, for example, may include non-volatile media (also referred to as non-volatile storage, memory, memory storage, memory circuitry and/or similar terms used herein interchangeably). The non-volatile storage or memory may include one or more non-volatile storage or memory media, including, but not limited to, hard disks, ROM, PROM, EPROM, EEPROM, flash memory, MMCs, SD memory cards, Memory Sticks, CBRAM, PRAM, FeRAM, NVRAM, MRAM, RRAM, SONOS, FJG RAM, Millipede memory, racetrack memory, and/or the like.

As will be recognized, the non-volatile storage or memory media may store databases, database instances, database management systems, data, applications, programs, program modules, scripts, source code, object code, byte code, compiled code, interpreted code, machine code, executable instructions, and/or the like. The term database, database instance, database management system, and/or similar terms used herein interchangeably may refer to a collection of records or data that is stored in a computer-readable storage medium using one or more database models, such as a hierarchical database model, network model, relational model, entity-relationship model, object model, document model, semantic model, graph model, and/or the like.

In addition, or alternatively, the memory elements 104 may include volatile memory. For example, the computing apparatus 110 may further include, or be in communication with, volatile media (also referred to as volatile storage memory, memory storage, memory circuitry and/or similar terms used herein interchangeably). In one embodiment, the volatile storage or memory may also include one or more volatile storage or memory media, including, but not limited to, RAM, DRAM, SRAM, FPM DRAM, EDO DRAM, SDRAM, DDR SDRAM, DDR2 SDRAM, DDR3 SDRAM, RDRAM, TTRAM, T-RAM, Z-RAM, RIMM, DIMM, SIMM, VRAM, cache memory, register memory, and/or the like.

As will be recognized, the volatile storage or memory media may be used to store at least portions of the databases, database instances, database management systems, data, applications, programs, program modules, scripts, source code, object code, byte code, compiled code, interpreted code, machine code, executable instructions, and/or the like being executed by, for example, the processing element 102. Thus, the databases, database instances, database management systems, data, applications, programs, program modules, scripts, source code, object code, byte code, compiled code, interpreted code, machine code, executable instructions, and/or the like may be used to control certain aspects of the operation of the computing apparatus 110 with the assistance of the processing element 102 and operating system.

As indicated, the computing apparatus 110 may also include one or more communication interfaces 108 for communicating with various computing entities, including computing entities 120, such as by communicating data, content, information, and/or similar terms used herein interchangeably that may be transmitted, received, operated on, processed, displayed, stored, and/or the like. The one or more communication interfaces 108, for example, may include one or more wired peripherals (e.g., fiber interfaces, ethernet ports, and/or the like), antenna, transmitters, receivers, digital to analog converters (DAC), analog to digital converters (ADC), modulators, demodulators, and/or the like. Such communication may be executed using a wired data transmission protocol, such as fiber distributed data interface (FDDI), digital subscriber line (DSL), Ethernet, asynchronous transfer mode (ATM), frame relay, data over cable service interface specification (DOCSIS), or any other wired transmission protocol. Similarly, the computing apparatus 110 may be configured to communicate via wireless external communication networks using any of a variety of protocols, such as general packet radio service (GPRS), Universal Mobile Telecommunications System (UMTS), Code Division Multiple Access 2000 (CDMA2000), CDMA2000 1X (1xRTT), Wideband Code Division Multiple Access (WCDMA), Global System for Mobile Communications (GSM), Enhanced Data rates for GSM Evolution (EDGE), Time Division-Synchronous Code Division Multiple Access (TD-SCDMA), Long Term Evolution (LTE), Evolved Universal Terrestrial Radio Access Network (E-UTRAN), Evolution-Data Optimized (EVDO), High Speed Packet Access (HSPA), High-Speed Downlink Packet Access (HSDPA), IEEE 802.9 (Wi-Fi), Wi-Fi Direct, 802.16 (WiMAX), ultra-wideband (UWB), infrared (IR) protocols, NFC protocols such as NFC-A, NFC-B, NFC-F, Wibree, Bluetooth protocols, wireless universal serial bus (USB) protocols, and/or any other wireless protocol.

The computing apparatus 110 may include input/output circuitry for communicating with one or more users. The input/output circuitry, for example, may include one or more user interfaces for providing and/or receiving information from one or more users of the computing apparatus 110. The input/output interfaces may include one or more tactile interfaces (e.g., keypads, touch screens, etc.), one or more audio interfaces (e.g., microphones, speakers, etc.), visual interfaces (e.g., display devices, etc.), and/or the like. The input/output circuitry may be configured to receive user input through one or more of the user interfaces from a user of computing apparatus 110 and provide data to a user through one or more of the user interfaces.

The following disclosure describes an improved GaN heterostructures that may be fabricated using improved fabrication techniques. The improved fabrication techniques modify traditional GaN heterostructures by adding back barrier contacts to reduce $R_{on}$ degradation and resistance of GaN devices among other benefits described herein.

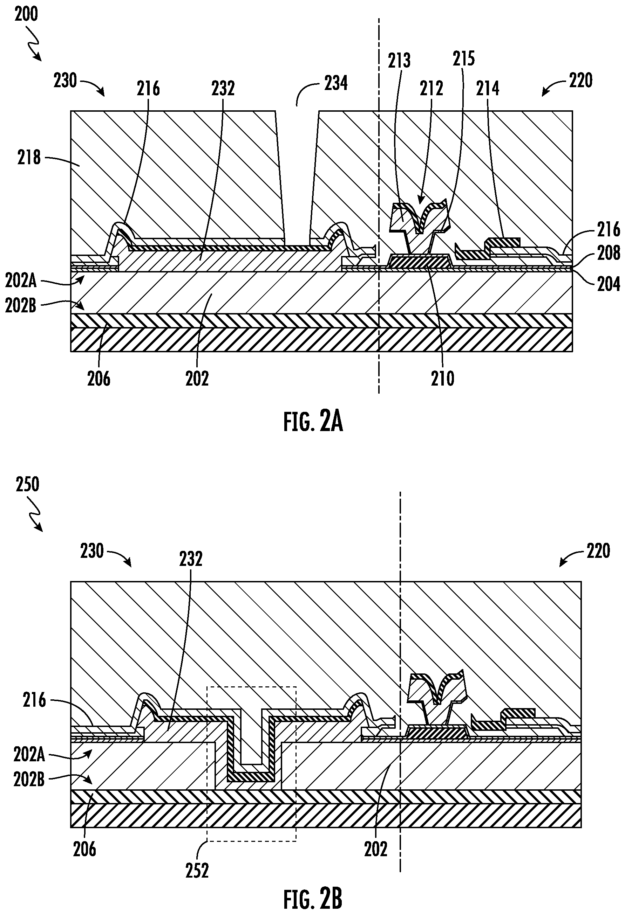

FIGS. 2A, 2B illustrate example sections of a GaN device. The GaN device, for example, may include a GaN high electron mobility transistor (HEMT). In a first section 200 (FIG: 2A), the GaN device includes a Via contact 324. In a second section 250 (FIG: 2B), the GaN device includes a back barrier contact 252.

With reference to FIG. 2A, the GaN device comprises a semiconductor base material 202 including a GaN material and having a first side 202A and a second side 202B. A frontside barrier layer 204 of a first AlGaN layer extends on the first side 202A. A backside barrier layer 206 of conductive material, such as a second AlGaN layer, extends on the second side 202B. In addition, or alternatively, the backside barrier layer 206 may include a magnesium GaN (MgGaN) layer.

The GaN device further includes an insulating layer 208 that is disposed over the frontside barrier layer 204. The insulating layer 208 may include any insulating material. For example, the insulating layer 208 includes an aluminum oxide ($Al_2O_3$) layer.

The GaN device includes a first region 220 and a second region 230 on the first side 202A of the semiconductor base material 202. The second region 230 may be adjacent to the first region 220.

The first region 220 includes a gate region that is positioned between a drain region (not depicted) and an ohmic source region (e.g., the second region 230) of the GaN device.

The first region 220 includes a pGaN structure. The pGaN structure includes a pGaN landing or pGaN region 210 on the first side 202A of the semiconductor base material 202. The pGaN landing 210 includes a conductive material that is directly in contact with the frontside barrier layer 204.

The pGaN structure further includes a metal gate 213 disposed on the pGaN landing 210. Metal gate 213 and pGaN landing 210 form a gate structure 212. In some examples, the metal gate 213 may be separated from the pGaN landing 210 by an insulating portion. The insulating portion may be formed by a portion of the insulating layer 208 and/or a gate contact dielectric 215. The metal gate 213 may include any metallic material, such as titanium nitride (TiN), and/or the like.

The first region 220 includes a field plate structure 214 and/or one or more substrate materials. The field plate structure 214, for example, may include a metallic structure placed at an edge of the gate structure 212 to reduce the peak electric field at the gate edge. In fact, a peak electric field at the gate edge might increase the breakdown voltage, weaken the strong field electron effect, suppress the current collapse, and increase the output power of the GaN device. The field plate structure 214 may include any metallic material, such as titanium nitride (TiN), and/or the like. For example, the field plate structure 214 may be the same material as the metal gate 213.

The structure shown in FIG. 2A further includes a substrate layer 216 and an insulating pad 218.

The substrate layer 216 is disposed over one or more metallic layers in the first region 220 and in the second region 230. For example, the substrate layer 216 may be initially disposed over the pGaN landing 210 and removed to form the gate structure 212. The substrate layer 216 may include any insulating material. As one example, the substrate layer 216 may include a silicon nitride (SiN) material.

The insulating pad 218 may include one or more portions of the same and/or different insulating material. For instance, the insulating pad 218 may include a silicon oxide ($SiO_2$) material.

The second region 230 includes an ohmic structure. The ohmic structure includes an ohmic contact 232. The ohmic contact 232 is disposed in direct contact with the semiconductor base material 202. The ohmic contact 232 may include a metallic layer that is formed on the first side 202A of the semiconductor base material 202 and through the semiconductor base material 202. The metallic layer, for example, may include a titanium (Ti), aluminum copper (AlCu), a titanium nitride (TiN), and/or any other metallic material.

The substrate layer 216 is formed at least partially over the ohmic contact 232.

In the first section 200 of the GaN device, the second region 230 includes a plurality of via contacts 234. Each via contact 234 includes here an opening in the insulating pad 218 and the substrate layer 216 to allow access to the ohmic contact 232.

With reference to FIG. 2B, the second section 250 of the GaN device has a similar structure as the first section 200 shown in FIG. 2A.

In particular, the second section 250 comprises a first region 220 and a second region 230.

The second region 230 of the second section 250 includes one or more back barrier contacts 252. The back barrier contact 252 includes a hole in the semiconductor base material 202 that allows the back barrier contact 252 to directly contact the backside barrier layer 206.

The back barrier contact 252 is an ohmic contact.

In other words, the hole in the semiconductor base material 202 extends across the semiconductor base material 202, between the first and the second side 202A, 202B

For example, the back barrier contact 252 may be fabricated by removing one or more portions of the semiconductor base material 202 below one or more contact positions within the second region 230 of the second section 250 to form one or more holes within the semiconductor base material 202. The back barrier contact 252 may be formed by depositing a metallic layer within the one or more holes, such that the metallic layer directly contacts the backside barrier layer 206. In this manner, the back barrier contact 252 includes a continuous metallic layer that is disposed at least partially on the first side 202A of the semiconductor base material 202 and at least partially on the second side 202B of the semiconductor base material 202.

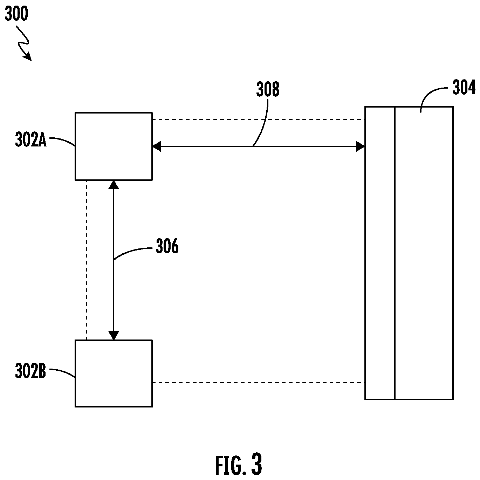

The second region 230 of the second section 250 includes one or more back barrier contacts 252 that are placed at one or more contact positions. For example, the contact positions may be strategically placed to reduce impact to resistance from one or more via contact dimensions. For example, a back barrier contact positioning scheme will now be further described with reference to FIG. 3.

FIG. 3 illustrates an example back barrier contact positioning scheme 300 in the second section 250. The back barrier contact positioning scheme 300 includes determining one or more contact positions 302A, 302B for one or more back barrier contacts of the GaN device. For example, the one or more contact positions 302A, 302B may be based at least in part on a drain position 304. For instance, the GaN device may include a drain electrode that is positioned across the second region 230 in the second section 250 of the semiconductor base material 202 (FIG. 2A). For example, with reference to FIG. 2B, the drain electrode may be positioned in a drain region that is separated from the second region 230 of the second section 250 by the first region 220 that includes pGaN gate.

Drain position 304 is indicative of a location of the drain on the semiconductor base material.

The one or more contact positions 302A-B are separated by at least a contact distance 306. The contact distance may be based at least in part on a drain distance 308 between the one or more contact positions 302A-B and the drain position 304. For example, the back barrier contact positioning scheme 300 may include determining the drain distance 308 and then determining the contact distance 306 based at least in part on the drain distance 308. The contact distance 306 may be within a threshold of the drain distance 308. For example, the contact distance 306 (below, indicated as LCC) may be approximate to the drain distance 308 (below, indicated as LCD) to optimize (e.g., lower) p-GaN resistance. P-GaN resistance, for example, may be expressed as:

$$\frac{\sqrt{LCD^2 + (\frac{LCC}{2})^2} - LCD}{LCD}$$

For example, the contact distance 306 (LCC) may be set to equal the drain distance 308 (LCDI), such that:

$$\frac{\sqrt{1 + \frac{1}{4}} - 1}{1}$$

which is approximately 12% and not expected to significantly impact the operation of a buried p-GaN layer.

As another example, the contact distance 306 (LCC) may be fixed at 1.5 um and the drain distance 308 (LDC ) may be fixed at 3.35 um.

The contact positions 302A-B may be leveraged to generate a GaN heterostructure with a plurality of back barrier contacts for optimizing performance of GaN HEMT devices.

The GaN heterostructure may be fabricated over a fabrication process that includes one or more fabrication stages.

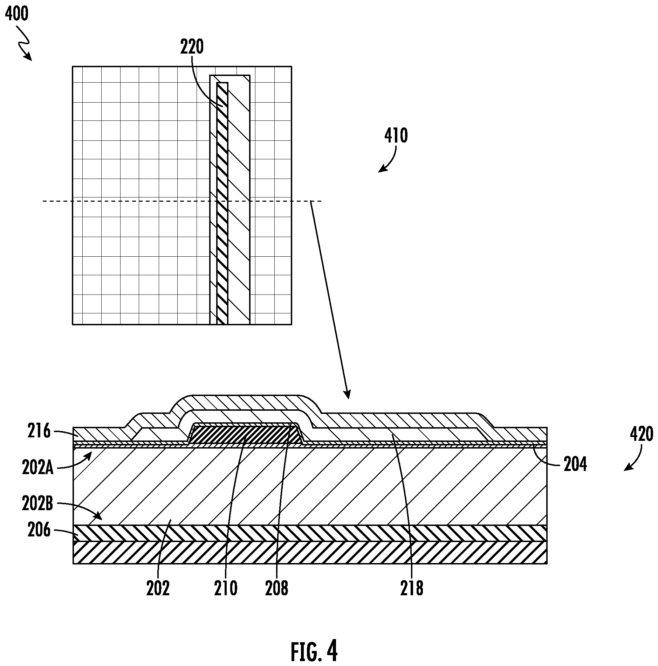

A first fabrication stage will now be discussed in more detail with reference to FIG. 4.

FIG. 4 illustrate an example first stage 400 of a GaN HEMT fabrication process..

During the first stage 400, the first region 220 of the semiconductor base material 202 is initially fabricated. Initially, the first stage 400 includes providing the semiconductor base material 202. The semiconductor base material 202 includes the first side 202A (e.g., a front side) and the second side 202B (e.g., a back side).The semiconductor base material 202 includes GaN material.

One or more barrier layers may be grown and/or deposited on the semiconductor base material 202. For example, the frontside barrier layer 204 is grown and/or deposited on the surface of the first side 202A of the semiconductor base material 202. The frontside barrier layer 204 includes an AlGaN layer.

The backside barrier layer 206 is grown and/or deposited on the surface of the second side 202B of the semiconductor base material 202. The backside barrier layer 206 may include the same material as the frontside barrier layer 204. For instance, the backside barrier layer 206 may include a second AlGaN layer. In addition, or alternatively, the backside barrier layer 206 may include a different material, such as a MgGaN material.

The pGaN landing 210 is formed on the frontside barrier layer 204. For instance, the pGaN landing 210 may be deposited and etched (e.g., using a resist strip and/or tetraethyl orthosilicate (TEOS) removal)..

The insulating layer 208 is formed over the frontside barrier layer 204 and the pGaN landing 210.The insulating layer 208 may include any insulating material, such as an $Al_2O_3$ layer. For example, the insulating layer 208 may be formed through an atomic layer deposition (ALD) process (e.g., $H_2O$-based 300 degree Celsius, etc.) to deposit $Al_2O_3$ layer over the first region 220 and the second region (not depicted) of the semiconductor base material 202. In this way, the pGaN landing 210 is sealed by the insulating layer 208.

A portion 218A of the insulating pad 218 is formed over the first region 220. For instance, the portion 218A of the insulating pad 218 may be formed through a PECVD process to deposit an $SiO_2$ layer over at least a portion of the first region 220 of the semiconductor base material 202. The portion 218A is formed over the pGaN landing 210 and at least a portion of the insulating layer 208. For example, the portion 218A may be applied by a sealing deposition PECVD to deposit a $SiH_4$-based $SiO_2$.

The substrate layer 216 is formed over the first region 220 and/or the second region (not depicted) of the semiconductor base material 202. The substrate layer 216 covers the portion 218A and the insulating layer 208. The substrate layer 216 may include a SiN material and may be deposited using a PECVD process. Since the substrate layer 216 is deposited after the formation of the pGaN landing 210, the substrate layer 216 covers the pGaN landing 210.

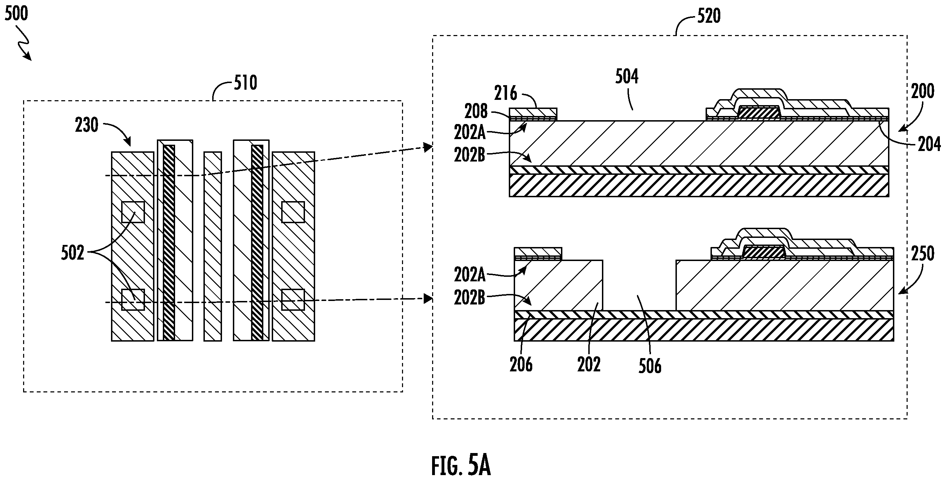

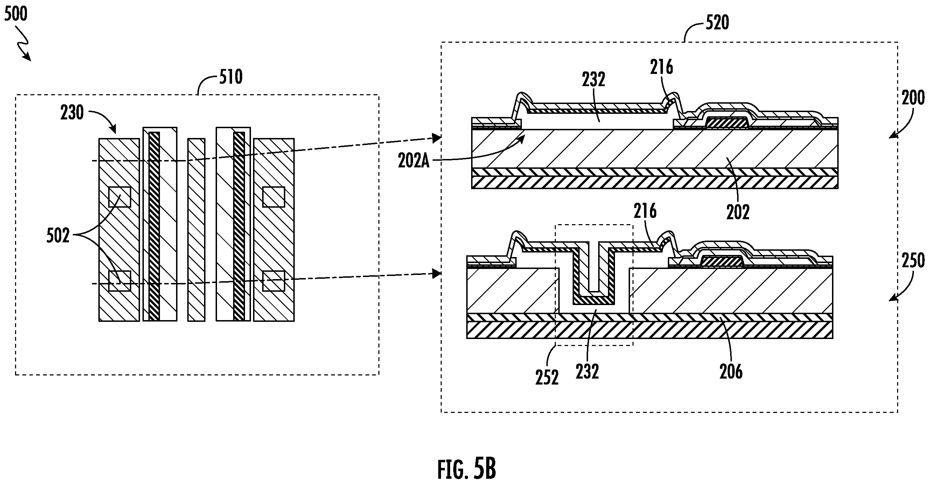

FIGS. 5A, 5B illustrate an example second stage 500 of the GaN HEMT fabrication process. The second stage 500 is depicted using a top view 510 and two sectional views 520 of a GaN device. The two sectional views 520 illustrate two fabrication operations on the first section 200 and the second section 250 of the GaN device. As described herein, the first section 200 corresponds to the section of the GaN device that includes one or more via landings, whereas the second section 250 includes one or more base barrier contacts at contact positions 502.

During the second stage 500, the second region 230 in both sections 200, 250 is initially fabricated on the first side 202A of the semiconductor base material 202.

The second stage 500 includes removing a first portion 504 of the frontside barrier layer 204 on at least a portion of the second region 230 of the first section 200 to form an ohmic contact. The first portion 504 is removed from the substrate layer 216, the insulating layer 208, and the frontside barrier layer 204 to expose a surface of the first side 202A of the semiconductor base material 202. That is, the first portion 504 is removed by removing a portion of the AlGaN layer, the $Al_2O_3$ layer and the $SiO_2$ layer that corresponds to contact position 502. The first portion 504 may be removed by etching (e.g., using a resist strip and/or polymer removal etching techniquesA) n ohmic contact, landing on the semiconductor base material 202.

In the second section 250, one or more second portions 506 of the semiconductor base material 202 are further removed to form one or more back barrier contact below the first portion 504. The one or more second portions 506 of the semiconductor base material 202 are removed below the one or more contact positions 502. The back barrier contact may be formed by etching the ohmic contact (e.g., using a resist strip and/or polymer removal etching techniques)to expose the backside barrier layer 206.

Second portions 506 may be narrower than the first portions 504.

Turning to FIG. 5B, the second stage 500 includes forming a metallic layer within the etched surfaces. Here, the second stage 500 includes forming a metallic layer over at least a portion of the second region 230 of both sections 200, 250.

In the first section 200, the metallic layer forms an ohmic contact 232 that directly contacts the surface of the first side 202A of the semiconductor base material 202.

In the second section 250, the metallic layer forms an ohmic contact 232 that directly contacts the backside barrier layer 206 through the semiconductor base material 202 at the one or more contact positions 502.

As described herein, the metallic layer may include a Ti, AlCu, TiN, and/or any other material suitable for an ohmic contact. The ohmic contact 232 may be deposited using one or more deposition techniques, such as those described herein.

The second stage 500 further includes forming substrate layer 216 over the metallic layer. The substrate layer 216 may be formed, for example, using a PECVD process to deposit a SiN layer (and/or similar material thereof) over the ohmic contact 232. At least a portion of the substrate layer 216 is thus formed after the formation of the ohmic contact 232, such that the substrate layer 216 covers the ohmic contact 232. The ohmic contact 232 may be annealed through an ohmic annealing process (e.g., thermal anneal, laser-based annealing, etc.).

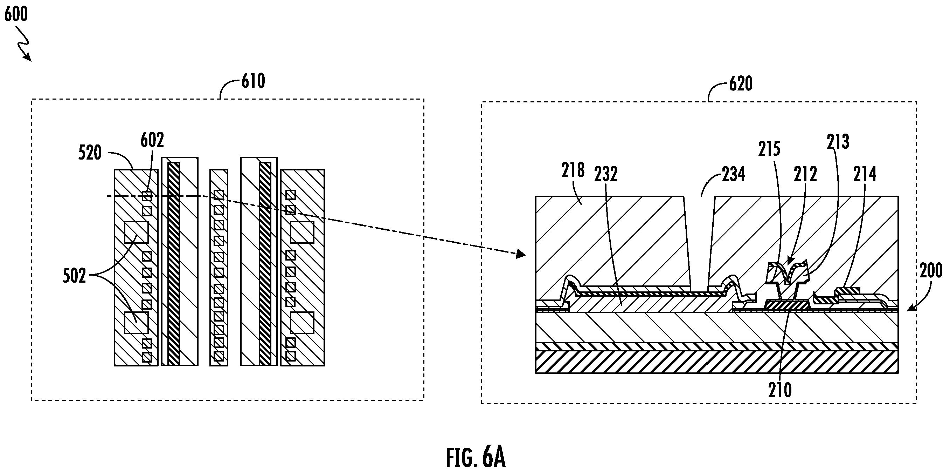

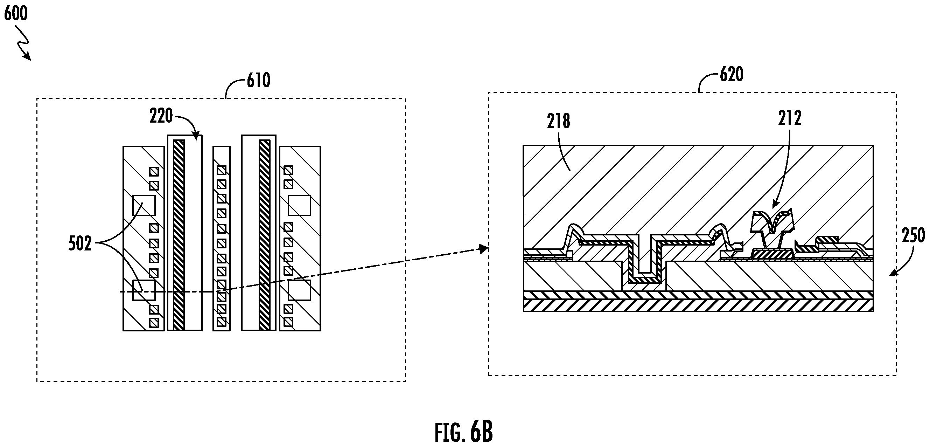

FIGS. 6A, 6B illustrate an example third stage 600 of the GaN HEMT fabrication process. The third stage 600 is depicted using a top view 610 and two sectional views 620. Sectional view 620 of FIG. 6A illustrates one or more fabrication operations on the first section 200 of the GaN device. Sectional view 620 of FIG. 6B illustrates one or more fabrication operations on the second section 250 of the GaN device. The second section 250 may correspond to one or more contact positions 502.

The third stage 600 includes selectively etching the substrate layer 216 (e.g., using a resist strip and/or polymer removal etching techniques), landing on portion 218A of the insulating pad 218.

The third stage 600 then includes forming the field plate structure 214 by depositing and defining a metal layer, such as a TiN material, at an edge of the pGaN landing 210 (e.g., using a resist strip and/or polymer removal etching techniques). This step may non be present, or performed later.

The third stage 600 includes forming gate contact dielectric 215 over the pGaN landing 210, e.g., through a PECVD process. Gate contact dielectric 215 may be of $Al_2O_3$.

The third stage 600 then includes forming a metal gate layer on the gate contact dielectric to form metal gate 213. The metal gate layer may include a titanium nitride (TiN) material, and/or the like.

If not done before, the field plate structure 214 may be formed by depositing, for example, metallic layer, such as titanium nitride (TiN).

The gate contact dielectric, the gate metal layer (and, in case, the field plate layer) may be defined together (e.g., using resist strip and polymer removal, etc.) to form the metal gate 213, the gate contact dielectric 215 (thus forming the pGaN structure 212) and the field plate structure 214.

The third stage 600 includes forming one or more contact via at one or more via positions 602 on the ohmic contact 232. The one or more via positions 602 may be separated from the one or more contact positions 502.

In particular, inter-metal dielectric layer is formed by depositing a dielectric (e.g., TEOS) using PECVD and chemical-mechanical planarization (CMP), thus obtaining the insulating pad 218 (e.g., through passivation deposition).

Multiple contact vias 234 are formed by selectively removing the inter-metal dielectric layers (e.g., using resist strip and/or polymer removal, etc.).

The pGaN device is finalized by forming W plugs through metal deposition and definition.

Turning to FIG. 6B, the one or more of the same operations may be performed in the second section 250 to form the gate structure 212 across each section of the first region 220 of the GaN device.

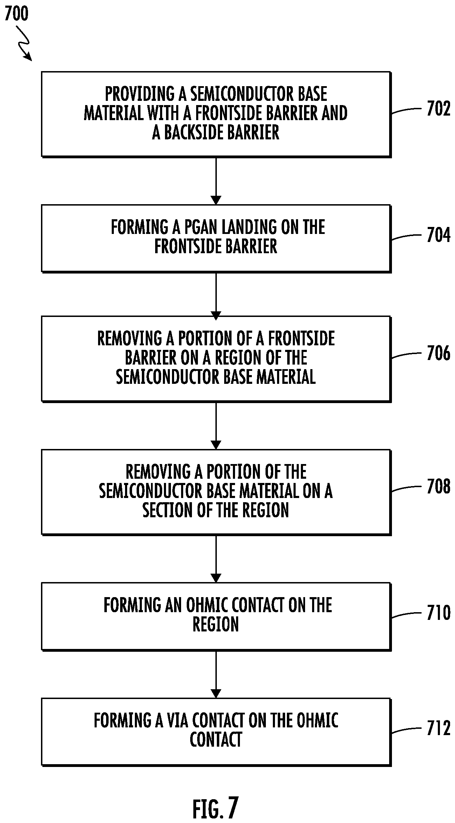

FIG. 7 illustrates a flowchart of an example method 700 for fabricating a GaN device. The flowchart depicts fabrication techniques for fabricating improved GaN devices that overcome various performance limitations of traditional GaN devices. The techniques may be implemented by one or more computing devices, entities, and/or systems described herein. For example, via the various steps/operations of the method 700, a computing device, such as the computing apparatus 110 described herein, may implement the techniques (e.g., via one or more control instructions to one or more computing entities 120) to overcome the various limitations with traditional GaN devices by reducing $R_{on}$ degradation, without increasing source to drain resistance.

Some of the steps/operations depicted may be performed in parallel or in a different sequence.

In FIG. 7, the method 700 includes, at step/operation 702, providing a semiconductor base material. For example, the method 700 includes providing a semiconductor base material having a first side and a second side, with a frontside barrier on the first side. A backside barrier may extend on the second side.. The semiconductor base material includes a GaN material.

The method 700 includes, at step/operation 704, forming a pGaN landing on the frontside barrier. For example, the method 700 may include forming the pGaN landing on a first region of the first side of the semiconductor base material. For example, the method 700 may include etching the pGAN landing. The method 700 may include forming, through an ALD process, an $Al_2O_3$ layer over the first region and the second region of the first side of the semiconductor base material. The $Al_2O_3$ layer covers the pGAN landing. The method 700 includes forming, through a PECVD process, a $SiO_2$ layer over the pGaN landing.

The method may include forming a substrate layer over the first region and the second region of the first side of the semiconductor base material. The substrate layer may cover the $SiO_2$ layer.

The method 700 may include forming a gate contact dielectric over the pGAN landing and the insulating layer(s), e.g., through a PECVD process.

The method 700 includes forming a metal gate on the pGaN landing to form a gate structure. The metal gate may include a TiN material.

The method 700 of FIG. 7 includes, at step/operation 706, removing a portion of the frontside barrier. For example, the method 700 may include removing the portion of the frontside barrier on at least one portion of the second region of the first side of the semiconductor base material to form an ohmic contact. In particular, removing the frontside barrier may include removing the $Al_2O_3$ layer, the $SiO_2$ layer, and/or the substrate layer.

The method 700 includes, at step/operation 708, removing a portion of the semiconductor base material. For example, one or more portions of the semiconductor base material are removed at one or more contact positions within the at least one portion of the second region to form one or more back barrier contacts. The one or more contact positions may be based at least in part on a drain position. The one or more contact positions may be separated by at least a contact distance.

The method 700 may include determining the drain distance and determining the contact distance based at least in part on the drain distance. The contact distance may be within a threshold of the drain distance.

The method 700 includes, at step/operation 710, forming an ohmic contact on the first region. For example, the method 700 may include forming a continuous ohmic contact across the first region of the semiconductor base material. For example, the method 700 includes forming a metallic layer over the at least one portion of the second region. The metallic layer may directly contact the backside barrier layer at the one or more contact positions. The metallic layer may include at least one of a titanium (Ti), an aluminum copper (AlCu), and/or a titanium nitride (TiN) material.

The method 700 may include forming a substrate layer over the metallic layer. The substrate layer may be formed using a PECVD process. The substrate layer may include an SiN material.

The method 700 includes, at step/operation 712, forming a contact via on the ohmic contact. For example, the method 700 may include forming one or more via contact at one or more via positions on the metallic layer. The one or more via positions are separated from the one or more contact positions.

The disclosed embodiments relate primarily to GaN power devices and techniques for fabricating GaN power devices, however, one skilled in the art may recognize that such principles may be applied to any semiconductor device.

Finally, it is clear that modifications and variations may be made to what has been described and illustrated herein, without thereby departing from the scope of this disclosure, as defined in the annexed claims.

For example, some steps may be done in a different order or may not be present.

By way of example, ohmic contact 232 may be formed before, simultaneously or after the gate structure 212; the same for field plate structure 214.

Examples of the present disclosure are the following:

Example 1. A method comprising:

providing a semiconductor base material comprising a first side and a second side, wherein the semiconductor base material comprises a gallium nitride (GaN) material, the first side comprises a frontside barrier layer, and the second side comprises a backside barrier layer;
forming a pGaN landing on a first region of the first side of the semiconductor base material;
removing a portion of the frontside barrier layer on at least one portion of a second region of the first side of the semiconductor base material to form an ohmic contact on the at least one portion of the second region; and
removing one or more portions of the semiconductor base material at one or more contact positions within the at least one portion of the second region to form one or more back barrier contacts.

Example 2. The method of example 1 further comprising forming a metallic layer over the at least one portion of the second region, wherein the metallic layer directly contacts the backside barrier layer at the one or more contact positions.

Example 3. The method of example 2, wherein the metallic layer may comprises a titanium (Ti), an aluminum copper (AlCu), or a titanium nitride (TiN) material.

Example 4. The method of example 2 further comprising forming one or more contact vias at one or more via positions on the metallic layer.

Example 5. The method of example 4, wherein the one or more via positions are separated from the one or more contact positions.

Example 6. The method of example 2 further comprising forming a substrate layer over the metallic layer.

Example 7. The method of example 6, wherein the substrate layer is formed using a plasma enhanced chemical vapor deposition (PECVD) process.

Example 8. The method of example 6, wherein the substrate layer comprises a silicon nitride (SiN) material.

Example 9. The method of example 1, wherein forming the pGaN landing comprises:

etching the pGAN landing on the first region of the first side of the semiconductor base material; forming, through an atomic layer deposition (ALD) process, an aluminum oxide ($A_2O_3$) layer over the first region and the second region of the first side of the semiconductor base material, wherein the $Al_2O_3$ layer covers the pGAN landing;

forming, through a plasma enhanced chemical vapor deposition (PECVD) process, a silicon oxide ($SiO_2$) layer over the pGaN landing; and forming a substrate layer over the first region and the second region of the first side of the semiconductor base material, wherein the substrate layer covers the $SiO_2$ layer.

Example 10. The method of example 9, wherein removing the portion of the frontside barrier layer on the second region further comprises removing the $Al_2O_3$ layer, the $SiO_2$ layer, and the substrate layer.

Example 11. The method of example 1, wherein the one or more contact positions are based at least in part on a drain position, wherein the drain position is indicative of a location of a drain on the semiconductor base material.

Example 12. The method of example 11, wherein the one or more contact positions are separated by at least a contact distance, wherein the contact distance is based at least in part on a drain distance between the one or more contact positions and the drain position.

Example 13. The method of example 12 further comprising:

determining the drain distance; and determining the contact distance based at least in part on the drain distance, wherein the contact distance is within a threshold of the drain distance.

Example 14. The method of example 1, further comprising forming a metal gate 213 on the pGaN landing to form a pGaN gate, wherein the metal gate 213 comprises a titanium nitride (TiN) material.

Example 15. The method of example 14, forming, through a plasma enhanced chemical vapor deposition (PECVD) process, a gate contact dielectric over the pGAN gate.

Example 16. A gallium nitride (GaN) device, comprising:

a semiconductor base material with a first side and a second side, wherein the semiconductor base material comprises a GaN material, the first side comprises an aluminum gallium nitride (AlGaN) layer, and the second side comprises a backside barrier layer;

a pGaN landing on a first region of the first side of the semiconductor base material;

an ohmic contact on a second region of the first side of the semiconductor base material; and one or more back barrier contacts at one or more contact positions within the second region.

Example 17. The GaN device of example 16, wherein the GaN device is a GaN high electron mobility transistor (HEMT).

Example 18. The GaN device of example 16, wherein the backside barrier layer comprises a second AlGaN layer or an MgGaN layer.

Example 19. The GaN device of example 16, further comprising a pGaN gate on the pGaN landing.

Example 20. The GaN device of example 16, further comprising one or more contact vias at one or more via positions within the second region, wherein the one or more via positions are separate from the one or more contact positions.

**Claims**

1. A method for manufacturing a gallium nitride device comprising:

providing a semiconductor base material (202) comprising a first side (202A) and a second side (202B), wherein the semiconductor base material comprises a gallium nitride -GaN-material, a frontside barrier layer (204) extending on the first side (202A), and a backside barrier layer (206) extending on the second side (202B);

forming a pGaN region (210) in a first region (220) on the first side of the semiconductor base material;

removing a portion of the frontside barrier layer (204) on at least one first and one second portions of a second region (230) of the semiconductor base material;

forming an ohmic contact (232) on at least one first portion of the second region;

removing one or more portions of the semiconductor base material (202) at one or more contact positions (502) within the at least one second portion of the second region (230); and forming one or more back barrier contacts (252) at the one or more contact positions (502), the back barrier contacts (252) electrically coupled to the backside barrier layer (206).

2. The method of claim 1, wherein forming one or more back barrier contacts (252) comprising forming a metallic layer (232) over the at least one portion of the second region (230), wherein the metallic layer directly contacts the backside barrier layer (206) at the one or more contact positions, the metallic layer (232) e.g. comprising a titanium (Ti), an aluminum copper, or a titanium nitride material.

3. The method of claim 2, wherein forming a metallic layer (232) comprises forming the ohmic contact (232).

4. The method of any of the preceding claims, further comprising forming one or more via contacts (234) at one or more via positions (602) on the metallic layer.

5. The method of the preceding claim, wherein the one or more via positions (602) are separated from the one or more contact positions (502).

6. The method of any of claims 2-5, further comprising forming a substrate layer (216) over the metallic layer, in particular using a plasma enhanced chemical vapor deposition process, the substrate layer preferably comprising a silicon nitride material.

7. The method of any of the preceding claims, wherein forming the pGaN region (210) comprises:

   defining the pGAN region in the first region (220);
   forming, preferably through an atomic layer deposition process, a first insulating layer (208), preferably of aluminum oxide, in the first region (220) and the second region (230), wherein the first insulating layer (208) covers the pGAN region (210);
   forming, preferably through a plasma enhanced chemical vapor deposition process, a second insulating layer (218A), preferably of silicon oxide, over the pGaN region; and
   forming a substrate layer (216) in the first region (220) and in the second region (230), wherein the substrate layer (216) covers the second insulating layer (218A).

8. The method of the preceding claim, wherein removing the portion of the frontside barrier layer (204) in the second region (230) further comprises removing the first insulating layer (208), the second insulating layer (218A), and the substrate layer (216).

9. The method of any of the preceding claims, further comprising forming a metal gate (213) on the pGaN region (210) to form a gate structure (212), wherein the metal gate (213) preferably comprises a titanium nitride material.

10. The method of the preceding claim, forming, preferably through a plasma enhanced chemical vapor deposition process, a gate contact dielectric (215) between the the pGAN region (210) and the metal gate (213).

11. A gallium nitride -GaN- device, comprising:

    a semiconductor base material (202) comprising a GaN material and having a first side (202A) and a second side (202B);
    a frontside barrier layer (204) on the first side (202A);
    a backside barrier layer (206) on the second side (202B);
    a pGaN region (210) on the first side of the semiconductor base material (202), in a first region (220) of the GaN device;
    an ohmic contact (232) on the first side of the semiconductor base material, in a second region (230) of the GaN device; and
    one or more back barrier contacts (252) at one or more contact positions (502) within the second region (230) of the GaN device, the back barrier contacts extending through the semiconductor base material (202) and being electrically coupled to the backside barrier layer (206), preferably in direct contact with the backside barrier layer (206).

12. The GaN device of the preceding claim 6, wherein the GaN device is a GaN high electron mobility transistor (HEMT).

13. The GaN device of claim 11 or 12, wherein the frontside barrier layer (204) comprise a AlGaN layer and the backside barrier layer (206) comprise a AlGaN layer or an MgGaN layer.

14. The GaN device of any of claims 11-13, further comprising a metal gate (213) on the pGaN region (210), forming a gate structure (212).

15. The GaN device of any of claims 11-14, further comprising one or more via contacts (234) at one or more via positions (602) within the second region, wherein the one or more via positions (602) are separate from the one or more contact positions (502).

FIG. 1

FIG. 2A

FIG. 2B

300

302A

308 304

306

302B

**FIG. 3**

400

220

410

216

202A

202B

206

202    210    208    218

420

204

FIG. 4

FIG. 5A

FIG. 5B

FIG. 6A

FIG. 6B

EP 4 550 975 A1

700

PROVIDING A SEMICONDUCTOR BASE
MATERIAL WITH A FRONTSIDE BARRIER AND
A BACKSIDE BARRIER — 702

FORMING A PGAN LANDING ON THE
FRONTSIDE BARRIER — 704

REMOVING A PORTION OF A FRONTSIDE
BARRIER ON A REGION OF THE
SEMICONDUCTOR BASE MATERIAL — 706

REMOVING A PORTION OF THE
SEMICONDUCTOR BASE MATERIAL ON A
SECTION OF THE REGION — 708

FORMING AN OHMIC CONTACT ON THE
REGION — 710

FORMING A VIA CONTACT ON THE OHMIC
CONTACT — 712

FIG. 7

Europäisches
Patentamt

European
Patent Office

Office européen
des brevets

# EUROPEAN SEARCH REPORT

Application Number

EP 24 20 9235

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/280093 A1 (CURATOLA GILBERTO [AT] ET AL) 12 September 2019 (2019-09-12) | 1,4-9, 11-15 | INV. H10D30/01 |
| Y | * Fig. 1 and 4-10 and and correlated text * | 2,3,10 | H10D30/47 H10D62/17 H10D64/23 |
| | ----- | | |
| A | US 2020/013862 A1 (SRIVASTAVA PUNEET [US] ET AL) 9 January 2020 (2020-01-09) * paragraphs [0034], [0035]; figure 2A * | 1-14 | |
| | ----- | | |
| Y | EP 3 217 433 A1 (IMEC VZW [BE]) 13 September 2017 (2017-09-13) | 2,3 | |
| A | * paragraphs [0041] - [0045]; figure 1 * | 1,4-14 | |
| | ----- | | |
| A | US 2020/119162 A1 (CURATOLA GILBERTO [AT] ET AL) 16 April 2020 (2020-04-16) * figures 1,2 * | 1-14 | |
| | ----- | | |
| A | US 2021/175350 A1 (IUCOLANO FERDINANDO [IT] ET AL) 10 June 2021 (2021-06-10) * Fig. 3, 6 and correlated text * | 1-14 | |
| | ----- | | **TECHNICAL FIELDS SEARCHED (IPC)** |
| Y | US 2006/138454 A1 (SAITO WATARU [JP] ET AL) 29 June 2006 (2006-06-29) * Fig. 1 and 4 and correlated text * | 10 | H10D |
| | ----- | | |

The present search report has been drawn up for all claims

| Place of search | Date of completion of the search | Examiner |
|---|---|---|
| Munich | 25 March 2025 | Melodia, Andrea |

EPO FORM 1503 03.82 (P04C01)

## ANNEX TO THE EUROPEAN SEARCH REPORT
## ON EUROPEAN PATENT APPLICATION NO.

EP 24 20 9235

This annex lists the patent family members relating to the patent documents cited in the above-mentioned European search report.
The members are as contained in the European Patent Office EDP file on
The European Patent Office is in no way liable for these particulars which are merely given for the purpose of information.

25-03-2025

| Patent document cited in search report | Publication date | Patent family member(s) | | Publication date |
|---|---|---|---|---|
| US 2019280093 A1 | 12-09-2019 | CN | 110233103 A | 13-09-2019 |
| | | EP | 3550610 A1 | 09-10-2019 |
| | | US | 2019280093 A1 | 12-09-2019 |
| US 2020013862 A1 | 09-01-2020 | CN | 112368843 A | 12-02-2021 |
| | | EP | 3818568 A1 | 12-05-2021 |
| | | TW | 202018947 A | 16-05-2020 |
| | | US | 2020013862 A1 | 09-01-2020 |
| | | WO | 2020010253 A1 | 09-01-2020 |
| EP 3217433 A1 | 13-09-2017 | EP | 3217433 A1 | 13-09-2017 |
| | | US | 2017263700 A1 | 14-09-2017 |
| US 2020119162 A1 | 16-04-2020 | CN | 110233104 A | 13-09-2019 |
| | | EP | 3561879 A2 | 30-10-2019 |
| | | US | 2019280100 A1 | 12-09-2019 |
| | | US | 2020119162 A1 | 16-04-2020 |
| US 2021175350 A1 | 10-06-2021 | CN | 112951908 A | 11-06-2021 |
| | | CN | 214797426 U | 19-11-2021 |
| | | EP | 3836228 A1 | 16-06-2021 |
| | | IT | 201900023475 A1 | 10-06-2021 |
| | | US | 2021175350 A1 | 10-06-2021 |
| US 2006138454 A1 | 29-06-2006 | JP | 4041075 B2 | 30-01-2008 |
| | | JP | 2005244072 A | 08-09-2005 |
| | | US | 2005189559 A1 | 01-09-2005 |
| | | US | 2006138454 A1 | 29-06-2006 |

EPO FORM P0459

For more details about this annex : see Official Journal of the European Patent Office, No. 12/82